# FASCICULE DE BREVET EUROPEEN

(11) **EP 0 499 496 B1**
(45) Date de publication et mention de la délivrance du brevet: **26.10.1994**
(21) Numéro de dépôt: 92400056.5
(22) Date de dépôt: 10.01.1992
(51) Int. Cl.: H05K 7/20, H05K 7/14

(54) **Tiroir ou bac pour cartes électroniques**
Einschuss oder Aufnahmerahmen für elektronische Karten
Drawer or rack for electronic cards

(30) Priorité: 15.02.1991 FR 9101803
(43) Date de publication de la demande: 19.08.1992
(73) Titulaire: TRANSRACK, 94380 Bonneuil sur Marne (FR)
(72) Inventeur: Demaille, Jean-Pierre, F-94100 Saint Maur des Fosses (FR); Billaud, Philippe, F-37260 Monts (FR)
(74) Mandataire: CABINET BONNET-THIRION

(56) Documents cités:
- EP-A- 0 092 104
- DE-A- 3 208 991
- FR-A- 2 346 941
- US-A- 4 486 816
- TECHNISCHE RUNDSCHAU,vol. 65, no. 8, 27 Février 1973, Hallwag Verlag, Bern, CH;page 53; Josef MAYR: "Einschubtechnik"

## Description

La présente invention concerne un tiroir ou bac destiné à recevoir des cartes électroniques et en particulier un tel tiroir ou bac utilisable pour le montage des équipements électroniques embarqués notamment dans le domaine des transports ferroviaires ou routiers.

US-A-4 486 816 révèle par exemple un boîtier destiné à recevoir des cartes électroniques.

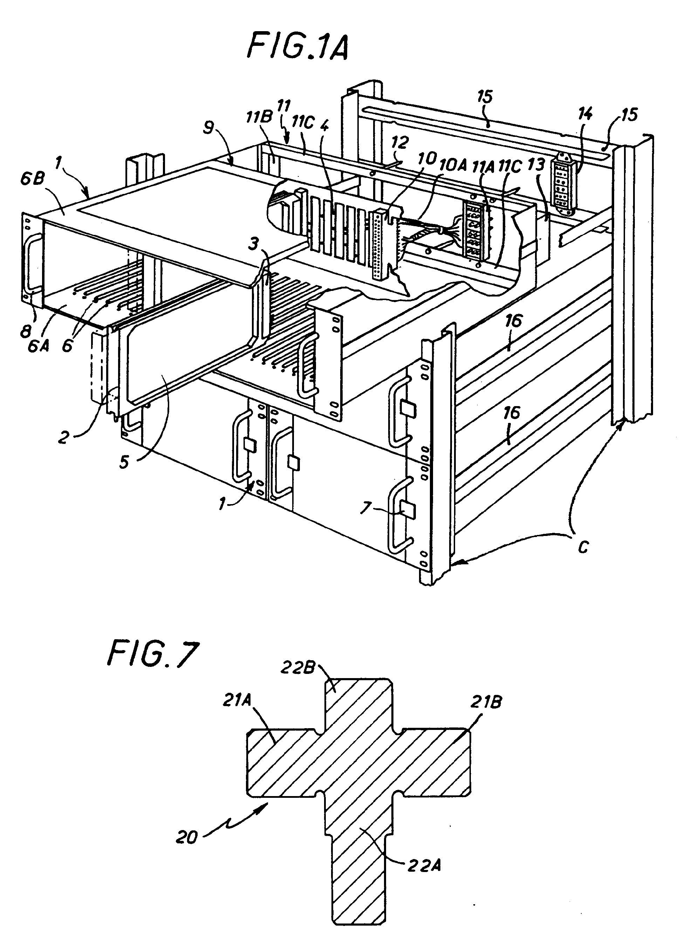

De façon générale, le système de montage des équipements électroniques embarqués est conçu de la façon suivante (voir figure 1A représentant en perspective une série de tiroirs 1 dans leur châssis C.

Une carte imprimée est fixée mécaniquement dans un cadre équipé 2 destiné à la renforcer et sur la partie arrière duquel est fixé un connecteur 3 dont les queues de contacts sont brasées sur la carte imprimée. Ce cadre équipé porte :
- à l'arrière, un système de codage mécanique 4 interdisant les erreurs de mise en place ;
- à l'avant, un emplacement disponible, permettant le montage éventuel de moyens de signalisation visibles lorsque la carte électronique est mise en place, outre la place nécessaire à la plaque indicatrice de fonction.

Cette carte électronique 5 ainsi réalisée est placée dans un tiroir 1 comportant des rails 6 pour la recevoir. Elle est immobilisée par un verrou 7. Le cadre 2 possède en outre une poignée de manoeuvre 8 de mise en place et de retrait de ladite carte électronique.

Pour ce qui est du tiroir lui-même, celui-ci comporte sur une cloison intermédiaire 9, les embases de connecteurs 10 qui reçoivent les fiches des connecteurs de cartes 3 et à sa partie arrière 11 des fiches de connecteurs de tiroirs 11A qui assurent la liaison électrique avec le câblage 10A d'un véhicule (non représenté) sur lequel l'ensemble est monté ou d'une armoire électrique (également non représentée) ; des broches de codage mécanique 12 sont prévues d'une part pour interdire les erreurs de montage des tiroirs et, d'autre part, pour guider l'approche des connecteurs. Par ailleurs des équerres de protection 13 sont fixées à ladite partie arrière du tiroir. Ce dernier est en outre fermé à sa partie avant par une plaque amovible (non représentée).

En outre, les tiroirs 1 montés dans leur châssis C, y sont supportés par des glissières latérales 16. Leur fond inférieur 6A est une face pleine ainsi que la partie haute 6B laquelle peut comporter des zones de configuration permettant une bonne aération des cartes.

Quant au châssis C, celui-ci porte les embases 14 des connecteurs de tiroirs et il comporte les trous 15 destinés à recevoir les broches 12 de codage mécanique des tiroirs.

Pratiquement dans la réalisation de cet ensemble de pièces, les deux flancs latéraux de chaque tiroir sont constitués par des plaques de tôles sur lesquelles sont fixés, par vis, les méplats qui forment les glissières 16. Par ailleurs la paroi arrière 11 de ces tiroirs est réalisée par l'assemblage de six pièces à savoir les deux éléments formant les montants verticaux tels que 11B, les deux éléments formant les deux pièces de liaisons horizontales 11C et enfin les deux pièces formant les équerres de protection 13. En outre les rails 6 de guidage des cartes sont fixés sur le fond plat inférieur 6A et sur la face interne de la partie haute 6B de chaque tiroir par rivetage. Ces modes de réalisation structures et assemblage non seulement nécessitent des opérations et manipulations multiples mais également de nombreuses pièces ou organes de liaison ou de fixation intermédiaire et d'accessoires tels que vis, boulons, rivets et analogues. Cela constitue des contraintes à la fabrication du produit désiré se traduisant par un coût de production relativement élevé faisant obligatoirement intervenir le calcul des durées de manipulation et le prix des pièces nécessaires au montage. De plus, étant donné le mode d'assemblage adopté, on ne peut assurer que des phénomènes de vibrations ne se produiront pas en cours d'usage et notamment en cours de transport.

La présente invention se propose donc de pallier ces inconvénients en réalisant un tiroir ou bac pour cartes électroniques supprimant au maximum les contraintes d'assemblage et évitant les risques de vibrations.

Ainsi un tiroir selon l'invention se caractérise en ce que ses deux flancs latéraux sont des profilés monoblocs présentant des bossages longitudinaux destinés à jouer le rôle de glissières, que sa paroi arrière est une pièce monobloc présentant le profil général désiré obtenu par pliage et cambrage d'une tôle, que ladite paroi arrière et lesdits flancs latéraux sont assemblés entre eux par simple vissage ou clivetage, que sa cloison intermédiaire est une pièce monobloc découpée dans un profilé, qu'une première paire d'entretoises avec découpes et profils appropriés fait partie de cet assemblage et constitue à l'avant dudit tiroir les poutres haute et basse de ce dernier, qu'une seconde paire d'entretoises avec découpes et profils appropriés fait également partie de cet assemblage et constitue en appui sur ladite cloison intermédiaire les poutres haute et basse correspondantes et qu'enfin des rails constitués par des profilés appropriés réunissent par simple emboîtement, d'une part lesdites poutres hautes avant et arrière et, d'autre part lesdites poutres basses avant et arrière pour former les faces hautes et basses du tiroir.

Suivant d'autres caractéristiques :
- lesdites poutres haute et basse, avant et arrière, sont obtenues par découpe dans un profilé pour présenter sur au moins une de leur tranche un système de mortaises destinées à coopérer avec un système de tenons prévus sur lesdits rails;
- lesdits rails sont des profilés comportant à leurs extrémités ledit système de tenons destinés à coopérer avec ledit système de mortaises prévu sur lesdites poutres ;
- lesdits rails constituent des parois à claire-voie.

De manière avantageuse lesdits rails sont réalisés en matière plastique.

D'autres caractéristiques et les avantages de l'invention ressortiront plus clairement de la description qui va suivre faite en regard des dessins annexés sur lesquels :
- la figure 1A est, comme vu précédemment, une vue en perspective d'un tiroir pour cartes électroniques, réalisé suivant la technique habituelle;
- la figure 1B est une vue en perspective correspondante d'un tiroir réalisé conformément à l'invention;
- la figure 2 est une vue en perspective de la paroi arrière d'un tiroir selon l'invention ;
- la figure 3 est une vue en coupe suivant III-III de la figure 1B ;
- la figure 4 est une vue en coupe suivant IV-IV de la figure 1B ;
- la figure 5 est une vue en perspective partielle à plus grande échelle suivant V-V de la figure 1B, avant l'assemblage des pièces entrant dans la réalisation de la partie haute d'un tiroir selon l'invention ;
- la figure 6 est une vue en perspective correspondante du fond plat inférieur dudit tiroir associé à la cloison intermédiaire de ce dernier et
- la figure 7 est une vue en coupe suivant VII-VII de la figure 5.

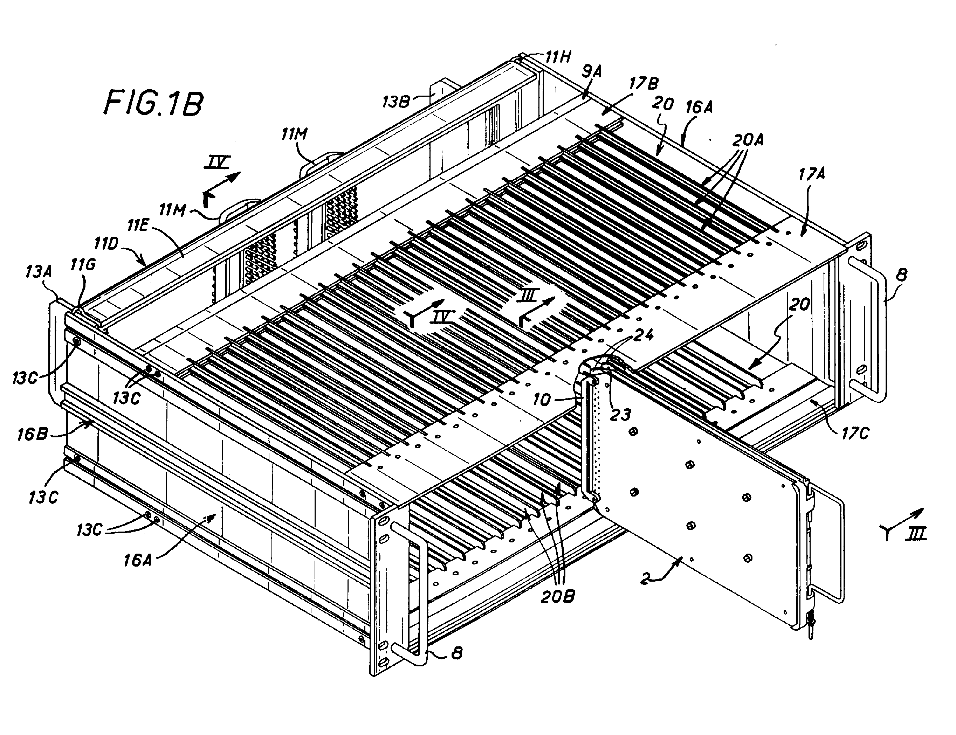

En se référant à ces figures un tiroir selon l'invention est constitué de deux flancs latéraux 16A réalisés dans des profilés monoblocs présentant des bossages longitudinaux 16B pour constituer le système de glissières coopérant avec les éléments de paroi ou de cloison du châssis (non représenté) dans lequel il est monté. Sur ces flancs peuvent être montées les poignées de manoeuvre 8. Il sont réunis entre eux par la paroi arrière 11D. Celle-ci consiste en une pièce monobloc obtenue par découpe, pliage et cambrage d'une tôle de matériau choisi (par exemple une tôle d'aluminium). On dispose ainsi d'une cloison affectant la forme d'un cadre dont les côtés tels que 11E, 11F résultent du pliage de la tôle après découpes au droit des coins telles qu'en 11G, 11H. La face plane 11K porte les trous 11L pour jouer les rôles et les fonctions voulus par exemple pour la pose des connecteurs tels que 11M. Par ailleurs une opération de découpe et de pliage a permis de réaliser les équerres 13A-13B qui correspondent aux équerres de protection 13 qui sont des pièces distinctes indépendantes rapportées dans les tiroirs du type actuellement en service et généralement adopté. Cette cloison 11D est donc rendue solidaire des flancs 16A par tout moyen approprié comme, par exemple, au moyen de vis, écrous, ou rivets (désignés par la référence 13C sur la figure 1B). De la même manière la cloison intermédiaire 9A est réalisée par découpes dans un profilé monobloc. Cette cloison est, à son tour, rendue solidaire des flancs 16A par les mêmes moyens 13C. Comme dans les tiroirs actuellement connus ces découpes prévoient les moyens 4A nécessaires pour le support des embases des connecteurs appropriés.

Un tiroir conforme à l'invention se caractérise en outre par la présence d'entretoises constituées par les poutres avant et arrière 17A-17B-17C-17D qui sont des plaques réalisées dans le matériau choisi approprié et qui, d'une part, sur leur tranche, comportent des rainures 18A-18B et, d'autre part, orthogonalement à ces rainures, des découpes 19 constituant un système de mortaises destinées à coopérer avec un système à tenons réalisé sur les rails de guidage des cartes électroniques comme décrit ci-après.

Les poutres avant 17A-17C sont rendues solidaires des flancs du tiroir par tous moyens appropriés du type vis, écrous, rivets etc.. et les poutres arrière 17B-17D sont rendues également solidaires des flancs dudit tiroir par les mêmes moyens.

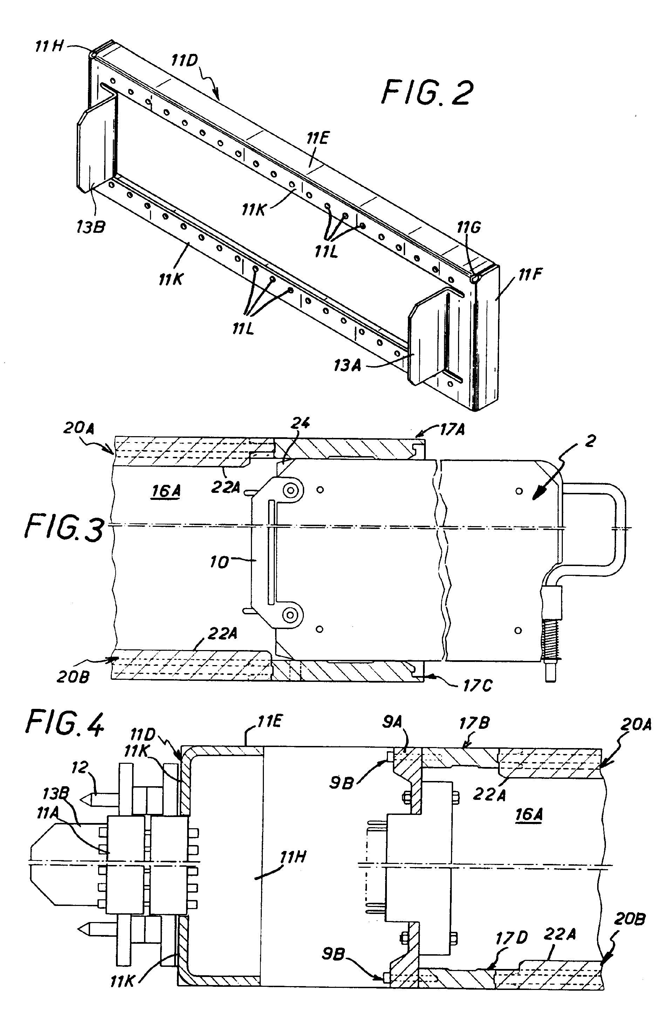

Lesdites poutres arrière 17B-17D servent en outre de supports à la cloison intermédiaire 9A qui est rendue solidaire desdites poutres par tous moyens appropriés du type vis, écrous, rivets et analogues (désignés par la référence 9B sur la figure 4).

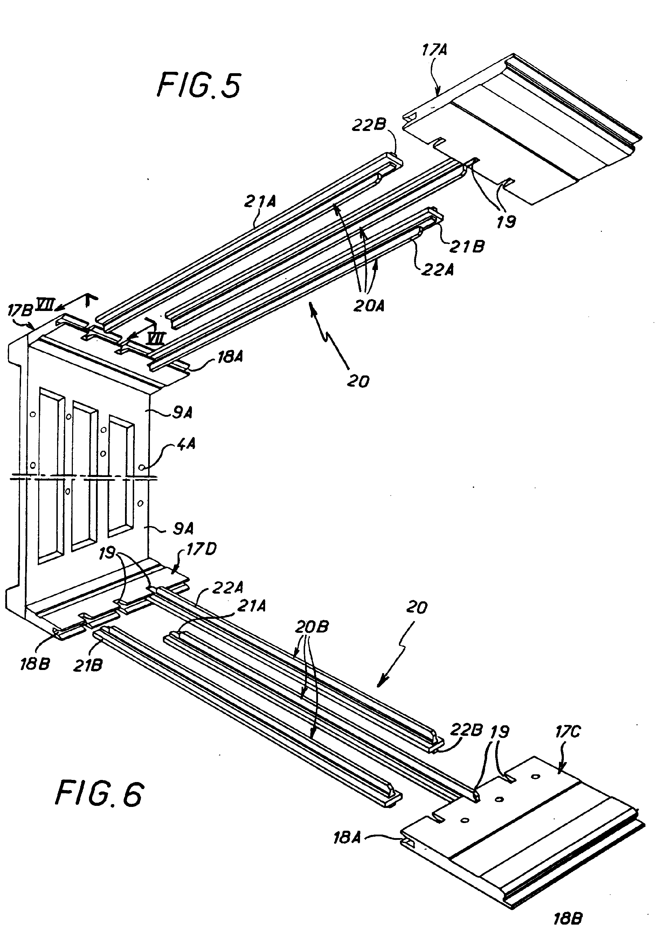

Les rails dont il est question ci-dessus sont constitués par des profilés 20 avantageusement en matière plastique affectant, vus en coupe transversale, un contour cruciforme. Les deux ailes 21A-21B de la partie horizontale de ce profilé cruciforme sont d'épaisseur au plus égale à la hauteur de la rainure 18A-18B correspondante avec laquelle elle est destinée à coopérer et les deux segments 22A-22B verticaux sont, suivant le mode de réalisation illustré, de hauteurs inégales, le segment 22A servant lui-même de guide principal étant appelé à s'insérer relativement profondément dans la rainure correspondante 23 réalisée dans le cadre équipé 2 d'un porte carte électronique muni de sa poignée 8. En se référant aux figures 5 et 6 on voit immédiatement qu'un assemblage du type tenons-mortaises permet de réaliser les faces supérieure et inférieure du tiroir avec les portions 22A (les plus hautes) dirigées vers l'intérieur dudit tiroir pour constituer autant de guides principaux.

La figure 5 illustre partiellement la face supérieure et la figure 6 la face inférieure d'un tiroir.

On constate alors immédiatement qu'une telle réalisation à claire-voie permet une meilleure aération des cartes électroniques comparativement à la réalisation actuellement connue qui ne prévoit que par endroits des zones dont la configuration comportant des orifices ou moyens analogues (non représentées) réalisés sur la face supérieure et/ou inférieure du tiroir, permet une aération. On notera que pour obtenir un bon guidage de la carte électronique et une insertion aisée, l'implantation des rails constituant la face supérieure du tiroir est telle que les extrémités de la série de rails 20, du côté de la face avant dudit tiroir sont en retrait vers l'intérieur par rapport aux extrémités de la série de rails 20 constituant la face inférieure de ce tiroir (comme on peut le voir à l'examen de la figure 3). On comprendra en effet qu'il suffit d'insérer le cadre porte-carte électronique pour qu'il soit sur un rail inférieur 20 et de pousser ce cadre vers l'intérieur du tiroir pour que la partie antérieure de la rainure 23 dont les lèvres 24 sont légèrement évasées vienne au contact du rail qui lui fait face pour assurer ainsi un guidage correct de ce cadre sans avoir besoin de tâtonner.

Bien entendu ledit cadre avec sa carte électronique est équipé de la même manière qu'à l'heure actuelle et les références sur les figures 3 et 4 se retrouvent sur la figure 1A désignant les éléments ou les organes qui ont déjà été définis.

De la description qui précède on se rend immédiatement compte que par suite des différences dues à la constitution ou à la structure de certaines pièces et que par suite du mode d'assemblage particulier qui en résulte, il est possible :
- de réaliser un tiroir porte carte électronique avec le minimum d'éléments accessoires de fixation supprimant ainsi les contraintes d'assemblage;
- d'éviter au maximum les phénomènes de vibrations qui sont eux-mêmes liés aux modes d'assemblage utilisés ;
- d'assurer une meilleure aération des cartes électroniques contenues dans un tel tiroir.

## Revendications

1. Tiroir ou bac pour cartes électroniques utilisable pour le montage des équipements électroniques embarqués notamment dans le domaine des transports ferroviaires ou routiers, les deux flancs latéraux (16A) du tiroir étant des profilés monoblocs présentant des bossages longitudinaux (16B) destinés à jouer le rôle de glissières dans les faces latérales du châssis (C) recevant ledit tiroir, la paroi arrière (11D) de ce dernier étant une pièce monobloc présentant le profil général désiré et obtenu par pliage et cambrage d'une tôle, ladite paroi arrière et lesdits flancs latéraux étant assemblés entre eux par des moyens simples appropriés (13C), une cloison intermédiaire (9A) faite d'une pièce monobloc découpée dans un profilé étant prévue au voisinage de ladite paroi arrière, une première paire d'entretoises (17A-17C) avec découpes et profils appropriés faisant partie de cet assemblage et constituant à l'avant dudit tiroir les poutres haute et basse de ce dernier, une seconde paire d'entretoises (17B-17D) avec découpes et profils appropriés faisant également partie de cet assemblage et constituant en appui sur ladite cloison intermédiaire les poutres haute et basse correspondantes et enfin des rails (20) constitués par des profils appropriés réunissant par simple emboîtement d'une part lesdites poutres hautes avant et arrière (17A-17B) et, d'autre part, lesdites poutres basses avant et arrière (17C-17D) pour former les faces supérieure et inférieure dudit tiroir.

2. Tiroir ou bac selon la revendication 1, caractérisé en ce que lesdites poutres hautes et basses (17A-17B, 17C-17D), avant et arrière, sont obtenues par découpe dans un profilé pour présenter sur au moins une de leur tranche un système de mortaises (18A-19) destinées à coopérer avec un système de tenons (21A-21B, 22A-22B) prévu sur lesdits rails (20).

3. Tiroir ou bac selon la revendication 1 ou 2, caractérisé en ce que lesdits rails (20) sont des profilés comportant en leurs extrémités ledit système de tenon destinés à coopérer avec ledit système de mortaises prévu sur lesdites poutres.

4. Tiroir ou bac selon l'une quelconque des revendications 1 à 3, caractérisé en ce que lesdits rails sont réalisés en matière plastique et sont de section cruciforme.

5. Tiroir ou bac selon l'une quelconque des revendications 1 à 4, caractérisé en ce que les faces supérieure et inférieure sont à claire-voie.

## Patentansprüche

1. Einschub oder Aufnahmerahmen für elektronische Karten, verwendbar für die Anordnung elektronischer Vorrichtungen, die besonders im Bereich des Transports auf Schiene oder Straße verladen werden, wobei die zwei seitlichen Flanken (16A) des Einschubs einstückige Profilbleche sind und Längsvorsprünge (16B) aufweisen, die Führungsschienen auf den seitlichen Flächen des Rahmens (C) bilden, der den Einschub aufnimmt, wobei ferner die Rückwand (11D) des Einschubs aus einem Stück besteht, das gewünschte allgemeine Profil aufweist und durch Krümmen und Biegen eines Bleches erhalten wird, wobei desweiteren die Rückwand und die seitlichen Flanken durch geeignete einfache Mittel (13C) miteinander verbunden sind, wobei ferner in der Nähe der Rückwand eine aus einem Stück gefertigte und in einem Profilblech gestanzte Zwischenwand (9A) vorgesehen ist, wobei des weiteren ein erstes Paar von Querverbindungen (17A-17C) mit geeigneten Stanzungen und Profilen Teil dieser Verbindung ist und am Vorderteil des Einschubs die obere und untere Verbindungsstrebe des Einschubs bildet, wobei ferner ein zweites Paar von Querverbindungen (17B-17D) mit geeigneten Stanzungen und Profilen ebenfalls Teil dieser Verbindung ist und zur Stützung der Zwischenwand die entsprechende obere und untere Verbindungsstrebe bildet, und wobei schließlich Schienen (20), die durch geeignete Profile gebildet werden, durch einfaches Ineinandergreifen einerseits die oberen vorderen und hinteren Verbindungsstreben (17A-17B) und andererseits die unteren vorderen und hinteren Verbindungsstreben (17C-17D) verbinden, um so die Ober- und Unterseite des Einschubs zu bilden.

2. Einschub oder Aufnahmerahmen nach Anspruch 1, dadurch gekennzeichnet, daß die oberen und unteren Verbindungsstreben (17A-17B, 17C-17D), vorne und hinten, durch Stanzung eines Profilblechs erhalten werden und so auf mindestens einem Abschnitt derselben ein System von Zapfenlöchern (18A, 19) aufweisen, die mit einem auf den Schienen (20) vorgesehenen System von Zapfen (21A-21B, 22A-22B) zusammenwirken.

3. Einschub oder Aufnahmerahmen nach Anspruch 1 oder 2, dadurch gekennzeichnet, daß die Schienen (20) Profilbleche sind, die an Ihren äußersten Enden das System von Zapfen aufweisen, die mit dem auf den Verbindungsstreben vorgesehenen System von Zapfenlöchern zusammenwirken.

4. Einschub oder Aufnahmerahmen nach einem der Ansprüche 1 bis 3, dadurch gekennzeichnet, daß die Schienen aus Kunststoff sind und von kreuzförmigem Querschnitt sind.

5. Einschub oder Autnahmerahmen nach einem der Ansprüche 1 bis 4, dadurch gekennzeichnet, daß die Ober- und die Unterseite aus einem Rost bestehen.

## Claims

1. A drawer or rack for electronic boards, which drawer or rack can be used for mounting items of on-board electronic equipment in particular in the field of railway or road transport, the two lateral flanks (16A) of the drawer being one-piece shaped portions having longitudinal projections (16B) intended to perform the function of sliding guides in the lateral faces of the chassis (C) receiving said drawer, the rear wall (11D) of the latter being a one-piece part of the desired general profile and produced by folding and bending of a metal sheet, said rear wall and said lateral flanks being assembled together by suitable simple means (13C), an intermediate partition (9A) made of a one-piece part cut out from a shaped portion being provided in the vicinity of said rear wall, a first pair of bracing struts (17A-17C) with suitable profiles and cut-outs forming part of said assembly and constituting at the front of said drawer the top and bottom beams of the latter, a second pair of bracing struts (17B-17D) with suitable profiles and cut-outs also forming part of said assembly and constituting in a condition of bearing against said intermediate partition the corresponding top and bottom beams and finally rails (20) formed by suitable shaped portions connecting by simple interengagement on the one hand said front and rear top beams (17A-17B) and on the other hand said front and rear bottom beams (17C-17D) to form the upper and lower faces of said drawer.

2. A drawer or rack according to claim 1 characterised in that said front and rear top and bottom beams (17A-17B, 17C-17D) are obtained by being cut out from a shaped portion to have on at least one of their edges a system of mortises (18A-19) intended to co-operate with a system of tenons (21A-21B, 22A-22B) provided on said rails (20).

3. A drawer or rack according to claim 1 or claim 2 characterised in that said rails (20) are shaped portions having at their ends said system of tenons which are intended to co-operate with said system of mortises provided on said beams.

4. A drawer or rack according to any one of claims 1 to 3 characterised in that said rails are of plastics material and are of cruciform section.

5. A drawer or rack according to any one of claims 1 to 4 characterised in that the upper and lower faces are of a grating-like structure.
